# EUROPÄISCHE PATENTSCHRIFT

(11) **EP 2 805 021 B1**
(45) Veröffentlichungstag und Bekanntmachung des Hinweises auf die Patenterteilung: **28.10.2020**
(21) Anmeldenummer: 13700865.2
(22) Anmeldetag: 14.01.2013
(51) Int. Cl.: C23C 4/134, C23C 4/11, F01D 5/28, C23C 4/18, C23C 16/02, C23C 16/56, C23C 16/40, C23C 14/58, C23C 14/08

(54) **VERFAHREN ZUR HERSTELLUNG EINER KERAMISCHEN SCHICHT AUF EINER AUS EINER NI-BASISLEGIERUNG GEBILDETEN OBERFLÄCHE**
METHOD FOR PRODUCING A CERAMIC LAYER ON A SURFACE FORMED FROM AN NI BASE ALLOY
PROCÉDÉ DE RÉALISATION D'UNE COUCHE CÉRAMIQUE SUR UNE SURFACE FORMÉE À PARTIR D'UN ALLIAGE À BASE DE NICKEL

(30) Priorität: 16.01.2012 DE 102012200560
(43) Veröffentlichungstag der Anmeldung: 26.11.2014
(73) Patentinhaber: Fraunhofer Gesellschaft zur Förderung der angewandten Forschung e.V., 80686 München (DE)
(72) Erfinder: FEHR, Karl Thomas, 81371 München (DE); YE, Yaping, Shaoxing Yuecheng Qu Zhejiang 312000 (CN); WOLF, Gerhard, 92242 Hirschau (DE)
(86) Internationale Anmeldenummer: PCT/EP2013/050577
(87) Internationale Veröffentlichungsnummer: WO 2013/107712

(56) Entgegenhaltungen:
- EP-A1- 0 605 196
- EP-A1- 1 591 550
- EP-A1- 1 829 984
- EP-A2- 0 816 526
- EP-A2- 1 640 477
- EP-A2- 2 309 024
- WO-A1-2007/112783
- DE-A1- 19 918 900
- US-A- 5 955 182
- US-A1- 2003 203 224
- US-A1- 2008 145 629
- PORTINHA A ET AL: "Characterization of thermal barrier coatings with a gradient in porosity", SURFACE AND COATINGS TECHNOLOGY, ELSEVIER, AMSTERDAM, NL, Bd. 195, Nr. 2-3, 31. Mai 2005 (2005-05-31), Seiten 245-251, XP027609210, ISSN: 0257-8972 [gefunden am 2005-05-31]

## Beschreibung

Die Erfindung betrifft ein Verfahren zur Herstellung einer keramischen Schicht auf einer aus einer Ni-Basislegierung gebildeten Oberfläche.

Nach dem Stand der Technik ist es beispielsweise aus Yoshiba, M. et al., "High-Temperature Oxidation and Hot Corrosion Behavior to Two Kinds of Thermal Barrier Coating Systems for Advances Gas Turbines", J. Therm. Spray Tech. 5 (1996), 259-268 bekannt, dass auf Ni-Basislegierungen keramische Schutzschichten beispielsweise mittels Plasmaspritzen aufgebracht werden können. Bei den keramischen Schutzschichten handelt es sich üblicherweise um Oxid-keramische Schutzschichten, insbesondere um mit Y₂O₃ stabilisiertes ZrO₂ (YSZ). Derartige keramische Schutzschichten verbessern den Korrosionswiderstand und die Verschleißbeständigkeit eines damit beschichteten Bauteils. Abgesehen davon werden solche keramischen Schutzschichten wegen ihrer geringen thermischen Leitfähigkeit und ihres hohen Reflexionsvermögens zur Wärmedämmung von Bauteilen im Turbinen- und Motorbau genutzt.

Bei einem Kontakt mit heißen korrosiven Medien kommt es nachteiligerweise zu einem Abplatzen der keramischen Schutzschichten. Yoshiba et al. (siehe oben) haben bei Heißkorrosionsuntersuchungen beobachtet, dass eine Beaufschlagung einer keramischen Schicht mit einer Salzschmelze aus Na₂SO₄ und NaCl zu einer Verbesserung der Haftfähigkeit beiträgt.

Die DE 689 11 363 T2 offenbart einen aus einer Ni-Basislegierung hergestellten Gegenstand, der mit einer keramischen Schutzschicht aus YSZ beschichtet ist. Zur Verbesserung der Haftfähigkeit werden vor dem Aufbringen der keramischen Schutzschicht auf dem Gegenstand zunächst eine oder mehrere Zwischenschichten abgeschieden.

Lima, C. R. C.; da Exaltação Trevisan, R.: Temperature Measurements and Adhesion Properties of Plasma Sprayed Thermal Barrier Coatings in Journal of Thermal Spray Technology, 8, 1999, 2, 323-327 offenbart ein Verfahren, bei dem auf einem aus einer Ni-Basislegierung hergestellten Substrat mittels Plasmaspritzen zunächst eine aus einem Metall und einer Keramik gebildete Zwischenschicht und nachfolgend eine ZrO₂ als einen Hauptbestandteil enthaltende keramische Schicht aufgebracht werden.

Guo, H. B.; Vaßen R.; Stöver D.: Atmospheric plasma sprayed thick thermal barrier coatings with high segmentation crack density in: Surface & Coatings Technology 186, 2004, 353-363 offenbart ein Verfahren, bei dem auf ein aus einer Ni-Basislegierung hergestellte Substrat eine Mischung aus einem Polymer und einem mit Yttrium stabilisierten ZrO₂ mittels Plasmaspritzen aufgetragen wird. Die so hergestellte poröse keramische Schicht mit ZrO₂ als Hauptbestandteil weist eine verbesserte thermische Zyklenbeständigkeit auf.

Die EP 1 829 984 A1 offenbart einen Gegenstand mit einer aus einer Ni-Basislegierung gebildeten Oberfläche und ein Verfahren zu dessen Herstellung. Auf der Oberfläche der Ni-Basislegierung wird eine Zwischenschicht als Haftschicht abgeschieden. Auf der Haftschicht wird eine keramische Schicht aus ZrO₂ als Hauptbestandteil abgeschieden, die eine Porosität aufweist.

Die EP 2 309 024 A2 sowie die US 2003/0203224 A1 offenbaren einen Gegenstand nach dem Oberbegriff des Patentanspruchs 10.

Aufgabe der Erfindung ist es, die Nachteile nach dem Stand der Technik zu beseitigen. Es soll insbesondere ein Verfahren zur Herstellung einer besonders haftfähigen keramischen Schicht auf einer aus einer Ni-Basislegierung gebildeten Oberfläche angegeben werden.

Diese Aufgabe wird durch die Merkmale der Ansprüche 1 und 10 gelöst. Zweckmäßige Ausgestaltungen der Erfindung ergeben sich aus den Merkmalen der Ansprüche 2 bis 9 und 11 bis 14.

Nach Maßgabe der Erfindung wird ein Verfahren zur Herstellung einer keramischen Schicht auf einer aus einer Ni-Basislegierung gebildeten Oberfläche mit folgenden Schritten vorgeschlagen:
Herstellen einer ZrO₂ als einen Hauptbestandteil enthaltenden keramischen Schicht auf der Oberfläche;

Herstellen einer Gasphase mit einer Temperatur im Bereich von 400 bis 900°C, bei der in einem aus einem inerten Gas mit einem Zusatz von 0,5 bis 10 Gew.% HCl gebildeten Trägergas ein aus einer Salzschmelze mit den Komponenten Alkalichlorid-Alkalisulfat-ZnCl₂ gebildeter Dampf enthalten ist; und

Inkontaktbringen der keramischen Schicht mit der Gasphase für eine Zeitdauer, welche ausreicht, damit sich zwischen der keramischen Schicht und der Oberfläche eine Zwischenschicht mit einer Dicke von zumindest 0,1 µm bildet.

Die mit dem erfindungsgemäßen Verfahren hergestellte keramische Schicht weist eine drastisch verbesserte Haftfestigkeit auf. Ferner zeichnet sich die keramische Schicht durch eine verbesserte Härte und eine verringerte Porosität aus.

Es wird angenommen, dass die in der Gasphase enthaltenden Komponenten im angegebenen Temperaturbereich ein quaternäres Eutektikum mit ZrO₂ bilden. Ferner wird angenommen, dass das in der Gasphase enthaltene HCl mit in der Ni-Basislegierung enthaltenem Chrom zu Chromchloriden reagiert. Infolge der chemischen Potentialdifferenz diffundieren die Chromchloride in Richtung der keramischen Schicht. Das ZrO₂ enthaltende Fluid diffundiert in Richtung der aus der Ni-Basislegierung gebildeten Grenzfläche. Im Bereich der Grenzfläche kommt es zu einer Rekristallisation, insbesondere des gelösten ZrO₂, und damit zur Ausbildung einer Zwischenschicht. Dabei vermindert sich im Bereich der Grenzfläche die Porosität der keramischen Schicht. Bei dem vorgeschlagenen Verfahren der Lösung, Umlagerung und Rekristallisation des keramischen Materials unter Einwirkung einer heißen salzhaltigen Gasphase handelt es sich um ein "solvothermales Verfahren".

Bei der Ni-Basislegierung handelt es sich zweckmäßigerweise um eine herkömmliche Ni-Basislegierung. Die Ni-Basislegierung enthält Cr, vorteilhafterweise in einer Menge von 15 bis 25 Gew.%.

Die keramische Schicht kann mittels PVD oder insbesondere auch durch thermisches Spritzen hergestellt sein. Beim thermischen Spritzen kann es sich insbesondere um Plasmaspritzen handeln.

Nach einer weiteren vorteilhaften Ausgestaltung der Erfindung enthält die keramische Schicht zur Stabilisierung des ZrO₂ als Nebenbestandteil Y₂O₃. Der Gehalt an Y₂O₃ kann 4 bis 8 Mol.% betragen.

Die keramische Schicht kann als weiteren Hauptstandteil Al₂O₃ enthalten. Der Gehalt an Al₂O₃ kann im Bereich von 30 bis 70 Mol.%, vorzugsweise im Bereich von 40 bis 60 Mol.%, besonders bevorzugt im Bereich von 50 Mol.%, liegen.

Zur Herstellung des Trägergases kann als Inertgas zweckmäßigerweise N₂ verwendet werden. Ferner kann das Trägergas zweckmäßigerweise 1,0 bis 4,0 Gew.% HCl enthalten.

Als Alkalichlorid und Alkalisulfat kommen insbesondere Salze in Betracht, welche als Alkali Na, K oder Li enthalten. Nach einer besonders vorteilhaften Ausgestaltung der Erfindung enthält die Salzschmelze als weitere Komponente ZnSO₄. Insbesondere kann die Salzschmelze folgende Komponenten enthalten: KCl-K₂SO₄-ZnCl₂-ZnSO₄. Eine Salzschmelze mit den vorgenannten Komponenten bildet ein quaternäres Eutektikum, welches eine Durchführung des Verfahrens mit einer Temperatur der Gasphase im Bereich von 700°C ermöglicht. - Es hat sich als zweckmäßig erwiesen, dass die Komponenten in im Wesentlichen äquimolarer Zusammensetzung in der Salzschmelze enthalten sind. Die Zusammensetzung kann von der äquimolaren Zusammensetzung um höchstens 5 Mol.%, bevorzugt weniger als 3 Mol.%, besonders bevorzugt weniger als 1 Mol.% abweichen.

Das Inkontaktbringen der keramischen Schicht mit der Gasphase erfolgt vorteilhafterweise für eine Zeitdauer, welche ausreicht, damit sich zwischen der keramischen Schicht und der Oberfläche eine Zwischenschicht mit einer Dicke von 0,5 bis 5,0 µm bildet. Die zu wählende Zeitdauer hängt von der Zusammensetzung der Salzschmelze, dem Druck und der Temperatur ab. Sie liegt bei einem Druck der Gasphase von 1000 bis 1500 hPa im Bereich von 1 bis 100 Stunden, vorzugsweise 20 bis 75 Stunden. Die Zeitdauer des Inkontaktbringens der keramischen Schicht mit der Gasphase kann durch eine Erhöhung des Drucks verringert werden.

Die Erfindung betrifft ferner einen Gegenstand mit den Merkmalen des Patentanspruchs 10.

Es wird ein Gegenstand mit einer aus einer Ni-Basislegierung gebildeten Oberfläche vorgeschlagen, wobei die Oberfläche unter Zwischenschaltung einer Zwischenschicht mit einer ZrO₂ als einen Hauptbestandteil enthaltenden keramischen Schicht beschichtet ist, und wobei die keramische Schicht eine Haftfestigkeit von zumindest 10 MPa aufweist. Zur Bestimmung der Haftfestigkeit wurden die Proben auf eine Temperatur von 1100°C erhitzt und bei dieser Temperatur 30 min gehalten. Anschließend wurden die Proben aus dem Ofen herausgenommen und an Luft auf Raumtemperatur abgekühlt. Der vorbeschriebene Zyklus wurde 20 mal wiederholt. Die Haftfestigkeit ist anschließend im Schertest mit dem Scherprüfgerät STM 20-A der Firma Walter & Bai AG ermittelt worden.

Es wird ferner ein Gegenstand mit einer aus einer Ni-Basislegierung gebildeten Oberfläche vorgeschlagen, wobei die Oberfläche unter Zwischenschaltung einer Zwischenschicht mit einer ZrO₂ als eine Hauptbestandteil enthaltenden keramischen Schicht beschichtet ist, und wobei die keramische Schicht eine thermische Zyklenbeständigkeit von mehr als 4 aufweist. Zur Bestimmung der thermischen Zyklenbeständigkeit wurden die Proben wie oben beschrieben zyklisch an Luft auf 1100°C in einem elektrischen Ofen für 30 min erhitzt und dann auf Raumtemperatur abgeschreckt. Anschließend wurde die Oberfläche mittels Rasterelektronenmikroskopie auf Abplatzungen hin untersucht.

Im Sinne der vorliegenden Erfindung handelt es sich bei dem "Gegenstand" um ein Bauteil, welches eine aus einer Ni-Basislegierung gebildete Oberfläche aufweist. Das Bauteil kann insgesamt aus der Ni-Basislegierung hergestellt sein. Es kann aber auch sein, dass das Bauteil lediglich abschnittsweise aus einer Ni-Basislegierung hergestellt ist. Eine Schichtdicke der Ni-Basislegierung ist dabei zweckmäßigerweise so gewählt, dass darauf eine keramische Schicht mittels PVD oder durch thermisches Spritzen aufgebracht werden kann.

Nach einer vorteilhaften Ausgestaltung weist die Zwischenschicht eine Dicke von 0,1 µm, vorzugsweise 0,5 bis 5,0 µm, auf. Infolge der solvothermalen Behandlung nimmt eine Porosität innerhalb der keramischen Schicht von einer Zwischenschicht in Richtung zu einer Schichtoberfläche der keramischen Schicht hin zu.

Die Porosität der keramischen Schicht beträgt in einem an die Zwischenschicht angrenzenden ersten Schichtabschnitt 0,5 bis 3,0% und in einem an die Schichtoberfläche angrenzenden zweiten Schichtabschnitt 2,5 bis 6,0%. Die Ermittlung der Porosität erfolgt dabei mittels Bildauswertung an einem Schliffbild.

Des Weiteren hat es sich als zweckmäßig erwiesen, dass die Ni-Basislegierung Cr in einer Menge von 5 bis 25 Gew.% enthält. Ferner enthält die keramische Schicht zur Stabilisierung des ZrO₂ als Nebenstandteil Y₂O₃. Die keramische Schicht kann als weiteren Hauptbestandteil Al₂O₃ enthalten.

Nachfolgend wird die Erfindung anhand der Zeichnungen näher erläutert. Es zeigen:
- Fig. 1: eine schematische Ansicht einer Vorrichtung zur solvothermalen Behandlung,
- Fig. 2: die Löslichkeit von ZrO₂ über der Temperatur in Abhängigkeit der Zusammensetzung der Gasphase,
- Fig. 3: eine REM-Aufnahme eines Querschnitts durch eine mit der keramischen Schicht beschichtete Oberfläche einer Ni-Basislegierung,
- Fig. 4: eine schematische Ansicht eines Querschnitts durch einen Gegenstand,
- Fig. 5: die Haftfestigkeit der keramischen Schicht einer herkömmlichen Probe im Vergleich zu einer erfindungsgemäßen Probe,
- Fig. 6a: eine REM-Aufnahme einer Oberfläche einer erfindungsgemäßen Probe ohne Thermolastwechsel,
- Fig. 6b: die Oberfläche gemäß Fig. 6a nach 20 Thermowechseln,
- Fig. 7: die thermische Zyklenbeständigkeit einer herkömmlichen Probe im Vergleich zu erfindungsgemäßen Proben,
- Fig. 8: der Reibungskoeffizient einer herkömmlichen Probe im Vergleich zu einer erfindungsgemäßen Probe,
- Fig. 9: die Vickers-Mikrohärte einer herkömmlichen Probe im Vergleich zu weiteren erfindungsgemäßen Proben und
- Fig. 10: die Porosität einer herkömmlichen Probe im Vergleich zu weiteren erfindungsgemäßen Proben.

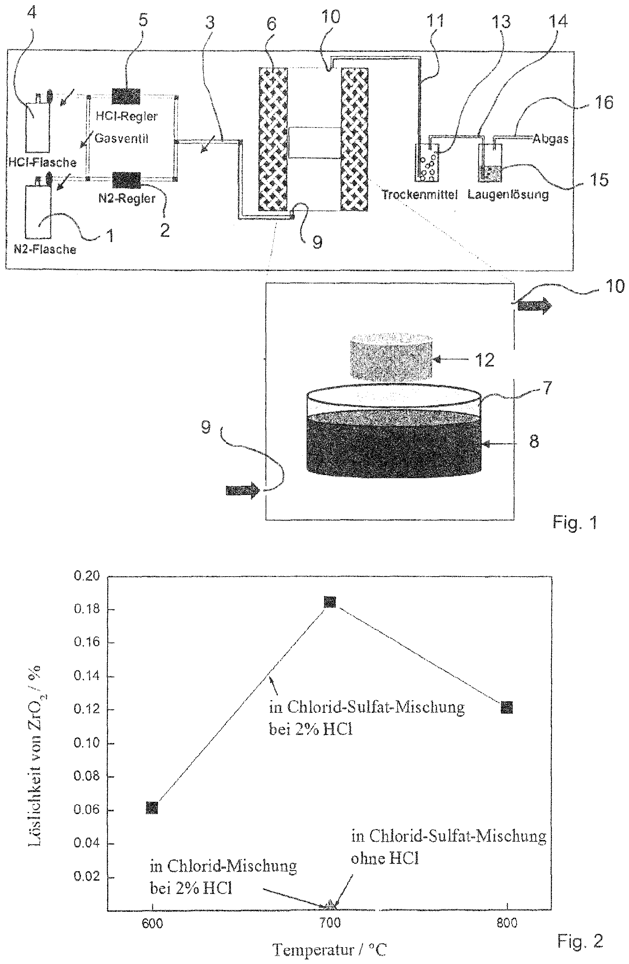

Bei der in Fig. 1 gezeigten Vorrichtung zur solvothermalen Behandlung ist ein Stickstoff-Gasvorrat 1 über ein erstes Gasregelventil 2 mit einer Gaszuführleitung 3 verbunden. Ein HCl-Gasvorrat 4 ist über ein zweites Gasregelventil 5 ebenfalls mit der Gaszuführleitung 3 verbunden. Die Gaszuführleitung 3 mündet in einen Ofen 6. Im Ofen 6 ist - wie aus der Ausschnittsvergrößerung ersichtlich ist - ein, beispielsweise aus Quarzglas hergestellter, Behälter 7 aufgenommen, in dem eine Salzschmelze 8 enthalten ist. Der Behälter 7 ist vorteilhafterweise an seiner der Salzschmelze 8 zugewandten Innenseite mit YSZ beschichtet (hier nicht gezeigt). Die Salzschmelze 8 kann in äquimolarer Zusammensetzung beispielsweise aus KCl-K₂SO₄-ZnCl₂-ZnSO₄ gebildet sein. Mit dem Bezugszeichen 9 ist ein Gaseinlass bzw. eine Mündung der Gaszuführleitung 3 bezeichnet. Mit dem Bezugszeichen 10 ist ein Gasauslass bzw. ein Ende einer Gasabführleitung 11 bezeichnet.

Im Ofen 6 ist oberhalb der Salzschmelze 8 eine Probe 12 angeordnet. Es kann sich dabei um einen Stahlzylinder handeln, der mit einer Ni-Basislegierung beschichtet ist, wobei die Ni-Basislegierung wiederum mit einer mittels thermischen Spritzens aufgebrachten keramischen Schicht aus YSZ beschichtet ist.

Die Gasabführleitung 11 mündet in einen ersten Behälter 13, in dem ein Trockenmittel aufgenommen ist. Vom ersten Behälter 13 wird das getrocknete Abgas über eine zweite Gasabführleitung 14 in einen zweiten Behälter 15 überführt, in dem eine Lauge aufgenommen ist. Das getrocknete und neutralisierte Abgas wird über eine Abgasleitung 16 abgeführt.

Fig. 2 zeigt die Löslichkeit von ZrO₂ in Abhängigkeit der Temperatur und in Abhängigkeit der Zusammensetzung der Gasphase. Die mit Quadraten kenntlich gemachten Messergebnisse zeigen die Löslichkeit von ZrO₂ in Abhängigkeit der Temperatur und bei Anwesenheit einer äquimolaren Salzschmelze 8 aus KCl-K₂SO₄-ZnCl₂-ZnSO₄, wobei als Trägergas N₂ mit einem Zusatz von 2 Gew.% HCl verwendet worden ist (= Modellsystem). Wie aus Fig. 2 ersichtlich ist, weist ZrO₂ eine maximale Löslichkeit bei einer Temperatur der Schmelze von 700°C auf. Dagegen zeigt das durch ein Dreieck kenntlich gemachte Messergebnis, dass sich ZrO₂ bei einer Weglassung von HCl im Trägergas oder einer Weglassung von Sulfatsalzen kaum in der Salzschmelze löst.

Zur Bestimmung der Löslichkeit von ZrO₂ wurden Probekörper aus YSZ in einer vorgegebenen Menge der Salzschmelze 8 für jeweils 72 Stunden bei der jeweils angegebenen Temperatur behandelt. Nachfolgend wurde die Salzschmelze 8 mittels ICPMS quantitativ analysiert.

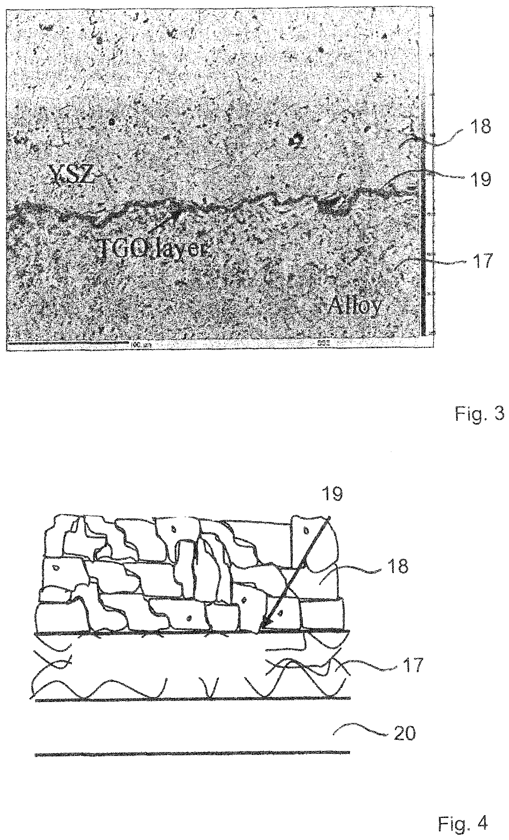

Fig. 3 zeigt eine REM-Aufnahme eines Querschnitts durch eine erfindungsgemäß behandelte Probe. Mit dem Bezugszeichen 17 ist eine herkömmliche Ni-Basislegierung, beispielsweise Alloy 625, bezeichnet. Die Ni-Basislegierung enthält 20 bis 23 Gew.% Cr sowie 8 bis 10 Gew.% Molybdän und als weitere Bestandteile insbesondere Tantal. Mit dem Bezugszeichen 18 ist eine keramische Schicht bezeichnet, welche aus YSZ hergestellt ist. Zwischen die Ni-Basislegierung 17 und die keramische Schicht 18 ist eine Zwischenschicht 19 eingeschaltet, welche hier eine Dicke von etwa 1,0 bis 3,0 µm aufweist. Die Zwischenschicht 19 ist das Ergebnis der vorgeschlagenen solvothermalen Behandlung der Probe. Sie enthält nach ersten Erkenntnissen im Wesentlichen Chromoxide, möglicherweise auch Anteile von Chromsulfiden. Sofern die keramische Schicht neben ZrO₂ als weiteren Hauptbestandteil auch Al₂O₃ enthält, ist in der Zwischenschicht 19 neben ZrO₂ wahrscheinlich auch Al₂O₃ enthalten.

Fig. 4 zeigt einen schematischen Querschnitt durch einen Gegenstand, der ein Substrat 20 bildet. Das Substrat 20 kann beispielsweise aus Stahl hergestellt sein. Das Substrat 20 kann zumindest abschnittsweise mit der Ni-Basislegierung 17 beschichtet sein, welche wiederum von der keramischen Schicht 18 überlagert ist. Durch die erfindungsgemäße solvothermale Behandlung der Probe ist zwischen der Ni-Basislegierung 17 und der keramischen Schicht 18 die Zwischenschicht 19 gebildet.

Infolge der solvothermalen Behandlung der keramischen Schicht und der dadurch bewirkten Umlagerungsprozesse nimmt deren Porosität in Richtung der Zwischenschicht 19 ab. Die nachfolgende Tabelle zeigt die Abhängigkeit der Verdichtungsrate im Bereich der keramischen Schicht 18 von der Temperatur, dem HCl-Gehalt in der Gasphase sowie dem Sulfatanteil in der Salzschmelze 8, wobei als Salzschmelze das System KCl-K₂SO₄-ZnCl₂-ZnSO₄ und als Trägergas N₂ verwendet worden sind:

| | | | | | | |
|---|---|---|---|---|---|---|
| **Temperatur (°C)** | 500 | 600 | 700 | 700 | 700 | 700 |
| **HCl-Anteil** | 2% | 2% | 2% | 4% | 8% | 2% |
| **Sulfatanteil** | 50% | 50% | 50% | 50% | 50% | 44% |
| **Verdichtungsrate** | <5µm/d | <5µm/d | 130µm/d | <10µm/d | <5µm/d | 40µm/d |

Wie aus der Tabelle ersichtlich ist, findet insbesondere bei einer Temperatur von 700°C, einem HCl-Gehalt von 2 Gew.% und einem Sulfatanteil von 50 Mol.%, d. h. einer äquimolaren Salzschmelze, eine besonders hohe Rekristallisation statt. Die Verdichtungsrate bzw. die Wachstumsrate der Verdichtungszone in der keramischen Schicht ist hier mit 130 pm/d besonders hoch.

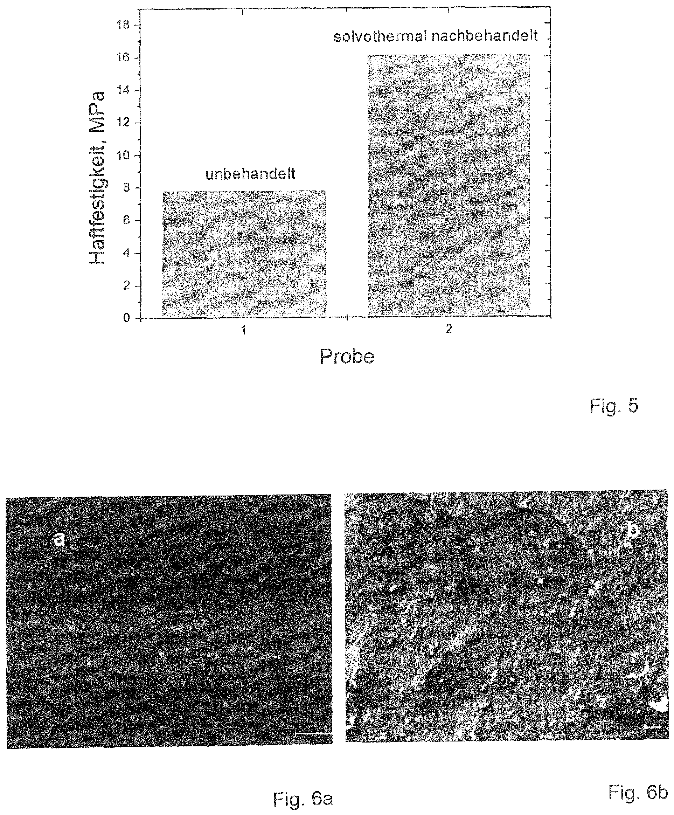

Fig. 5 zeigt die Ergebnisse von Messungen der Haftfestigkeit einer keramischen Schicht aus YSZ, welche mittels Plasmaspritzen auf die Ni-Basislegierung, Alloy 625, aufgebracht worden ist. Im Falle der solvothermalen Behandlung der keramischen Schicht hat sich eine Zwischenschicht 19 mit einer Dicke von etwa 1,0 µm ausgebildet. Wie aus den Ergebnissen ersichtlich ist, ist die Haftfestigkeit der solvothermal behandelten Probe etwa doppelt so hoch wie die der herkömmlichen Probe.

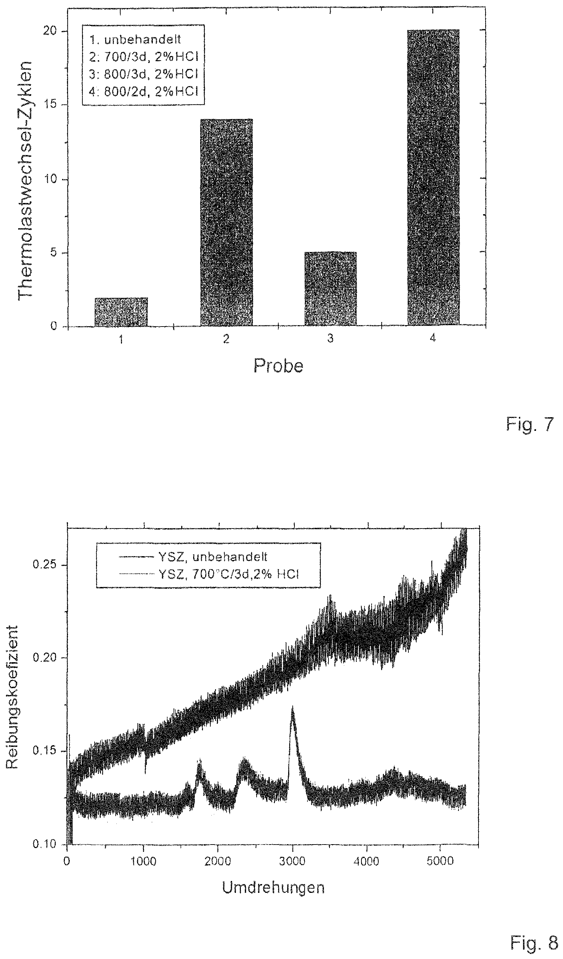

Die Fig. 6a, 6b sowie 7 zeigen die Ergebnisse der thermischen Zyklenbeständigkeit der vorgenannten Proben. Die thermischen Zyklenbeständigkeit ist mittels REM-Bildern der Oberflächen ermittelt worden. Fig. 6a zeigt die Oberfläche einer solvothermal behandelten Probe vor Beginn der Thermolastwechsel-Zyklen. Fig. 6b zeigt dieselbe Oberfläche nach 20 Thermolastwechsel-Zyklen. Wie insbesondere aus Fig. 7 ersichtlich ist, werden bei unbehandelten Proben bereits nach 2 Thermolastwechsel-Zyklen Abplatzungen der keramischen Schicht beobachtet. Bei den vorliegenden Untersuchungen wurde die thermische Zyklenbeständigkeit definiert als der Zeitpunkt, zu dem 20% der keramischen Schicht abgeplatzt waren. Wie weiter aus Fig. 7 ersichtlich ist, zeigen einige der solvothermal behandelten Proben eine drastisch verbesserte Thermoschockbeständigkeit im Vergleich zur unbehandelten Probe.

Fig. 8 zeigt die tribologischen Eigenschaften einer herkömmlichen Probe und einer solvothermal behandelten Probe, deren keramische Schicht wiederum aus YSZ bestanden hat. Die in Fig. 8 gezeigten Messergebnisse sind mittels Kugel-Schiebe-Tribometer im "Three ball on disc-Test" gemessen worden. Wie aus Fig. 8 ersichtlich ist, zeigen die erfindungsgemäß behandelten Proben einen um den Faktor 3 reduzierten Reibungskoeffizienten.

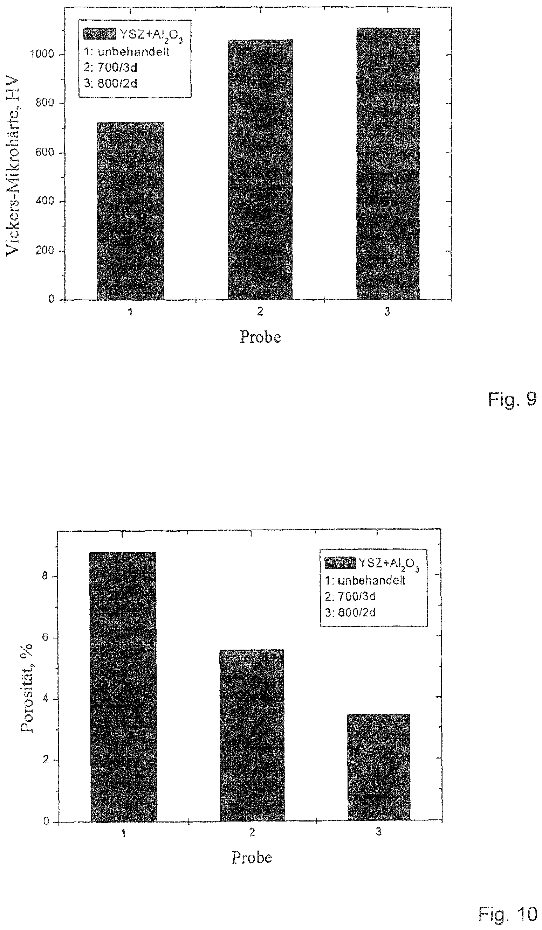

Die Fig. 9 und 10 betreffen Ergebnisse von Untersuchungen an weiteren Proben, bei denen die keramische Schicht jeweils aus einer äquimolaren Mischung von YSZ und Al₂O₃ bestanden hat. Die keramische Schicht ist wiederum mittels Plasmaspritzen auf eine Unterlage aus einer Ni-Basislegierung, Alloy 625, aufgebracht worden. Die solvothermale Nachbehandlung ist wiederum unter Verwendung des unter Fig. 2 beschriebenen Modelsystems bei einer Temperatur von 700°C erfolgt.

Wie aus Fig. 9 ersichtlich ist, zeigen die solvothermal behandelten Proben eine deutlich verbesserte Vickers-Mikrohärte. Aus Fig. 10 ist ersichtlich, dass die solvothermal behandelten Proben außerdem eine drastisch verringerte Porosität aufweisen.

Die Abnahme der Porosität kommt bei den solvothermal behandelten Proben dadurch zustande, dass sich durch das Einwirken der Gasphase YSZ und/oder Al₂O₃ lösen und in Richtung der durch die Ni-Basislegierung gebildeten Grenzfläche diffundieren. Dort findet eine Rekristallisation der gelösten keramischen Phase statt, wodurch insbesondere der Porenraum der keramischen Schicht im Bereich der Grenzfläche verfüllt wird. Die solvothermal behandelten Proben zeichnen sich also nicht nur durch die Ausbildung einer Zwischenschicht zwischen der Ni-Basislegierung und der keramischen Schicht, sondern auch durch eine von der Schichtoberfläche der keramischen Schicht in Richtung zur Grenzfläche abnehmenden Porosität innerhalb der keramischen Schicht aus. - Mittels thermischen Spritzens hergestellte herkömmliche Schichten weisen in der Regel eine Porosität im Bereich von 9% auf. Demgegenüber weisen solvothermal behandelte keramische Schichten eine drastisch reduzierte Porosität im Bereich von 3 bis 5,5% auf. Die Angaben der Porosität beziehen sich hier wiederum auf Ergebnisse, welche mittels Bildauswertung am Schliffbild ermittelt worden sind.

### Bezugszeichenliste

- 1: Stickstoff-Gasvorrat
- 2: erstes Gasregelventil
- 3: Gaszuführleitung
- 4: HCl-Gasvorrat
- 5: zweites Gasregelventil
- 6: Ofen
- 7: Behälter
- 8: Salzschmelze
- 9: Gaseinlass
- 10: Gasauslass
- 11: Gasabführleitung
- 12: Probe
- 13: erster Behälter
- 14: weitere Gasabführleitung
- 15: zweiter Behälter
- 16: Abgasleitung
- 17: Ni-Basislegierung
- 18: keramische Schicht
- 19: Zwischenschicht
- 20: Substrat

## Patentansprüche

1. Verfahren zur Herstellung einer keramischen Schicht (18) auf einer aus einer Ni-Basislegierung (17) gebildeten Oberfläche, mit folgenden Schritten:
Herstellen einer ZrO₂ als einen Hauptbestandteil enthaltenden keramischen Schicht (18) auf der Oberfläche;
Herstellen einer Gasphase mit einer Temperatur im Bereich von 400 bis 900°C, bei der in einem aus einem inerten Gas mit einem Zusatz von 0,5 bis 10 Gew.% HCl gebildeten Trägergas ein aus einer Salzschmelze (8) mit den Komponenten Alkalichlorid-Alkalisulfat-ZnCl₂ gebildeter Dampf enthalten ist; und
Inkontaktbringen der keramischen Schicht (18) mit der Gasphase für eine Zeitdauer, welche ausreicht, damit sich zwischen der keramischen Schicht (18) und der Oberfläche eine Zwischenschicht (19) mit einer Dicke von zumindest 0,1 µm bildet.

2. Verfahren nach Anspruch 1, wobei die keramische Schicht (18) mittels PVD oder durch thermisches Spritzen hergestellt wird.

3. Verfahren nach einem der vorhergehenden Ansprüche, wobei als Inertgas N₂ verwendet wird.

4. Verfahren nach einem der vorhergehenden Ansprüche, wobei das Trägergas 1,0 bis 4,0 Gew.% HCl enthält.

5. Verfahren nach einem der vorhergehenden Ansprüche, wobei die Salzschmelze (8) als weitere Komponente ZnSO₄ enthält.

6. Verfahren nach einem der vorhergehenden Ansprüche, wobei die Salzschmelze (8) folgende Komponenten enthält: KCl-K₂SO₄-ZnCl₂-ZnSO₄.

7. Verfahren nach einem der vorhergehenden Ansprüche, wobei die Komponenten in im Wesentlichen äquimolarer Zusammensetzung in der Salzschmelze (8) enthalten sind.

8. Verfahren nach einem der vorhergehenden Ansprüche, wobei das Inkontaktbringen der keramischen Schicht (18) mit der Gasphase für eine Zeitdauer erfolgt, welche ausreicht, damit sich zwischen der keramischen Schicht (18) und der Oberfläche eine Zwischenschicht (19) mit einer Dicke von 0,5 bis 5,0 µm bildet.

9. Verfahren nach einem der vorhergehenden Ansprüche, wobei die Zeitdauer 1 bis 100 Stunden, vorzugsweise 20 bis 75 Stunden, beträgt.

10. Gegenstand mit einer aus einer Ni-Basislegierung (17) gebildeten Oberfläche, wobei die Oberfläche unter Zwischenschaltung einer Zwischenschicht (19) mit einer ZrO₂ als einen Hauptbestandteil enthaltenden keramischen Schicht (18) beschichtet ist, und wobei die keramische Schicht (18) eine Haftfestigkeit von zumindest 10 MPa aufweist oder wobei die keramische Schicht (18) eine thermische Zyklenbeständigkeit von mehr als 4 aufweist, wobei der Gegenstand zur Bestimmung der Zyklenbeständigkeit auf eine Temperatur von 1100°C erhitzt, bei dieser Temperatur 30 min gehalten und anschließend an Luft auf Raumtemperatur abgekühlt wird,
**dadurch gekennzeichnet, dass**
eine Porosität der keramische Schicht (18) innerhalb der keramischen Schicht (18) von einer Grenzfläche zur Zwischenschicht (19) in Richtung zu einer Schichtoberfläche der keramischen Schicht (18) hin zunimmt, wobei die Porosität in einem an die Zwischenschicht angrenzenden ersten Schichtabschnitt 0,5 bis 3,0% und einem an die Schichtoberfläche angrenzenden zweiten Schichtabschnitt 2,5 bis 6,0% beträgt.

11. Gegenstand nach Anspruch 10, wobei die Zwischenschicht (19) eine Dicke von zumindest 0,1 µm, vorzugsweise 0,5 bis 5,0 µm, aufweist.

12. Gegenstand nach einem der Ansprüche 10 oder 11, wobei die Ni-Basislegierung (17) Cr in einer Menge von 15 bis 25 Gew.% enthält.

13. Gegenstand nach einem der Ansprüche 10 bis 12, wobei die keramische Schicht (18) zur Stabilisierung des ZrO₂ als Nebenbestandteil Y₂O₃ enthält.

14. Gegenstand nach einem der Ansprüche 10 bis 13, wobei die keramische Schicht (18) als weiteren Hauptbestandteil Al₂O₃ enthält.

## Claims

1. Method of forming a ceramic layer (18) on a surface formed of a Ni-base alloy (17), comprising the steps of:
producing a ceramic layer (18) containing ZrO₂ as a main component on the surface;
producing a gas phase having a temperature in the range of 400 to 900°C, wherein a vapor formed from a molten salt (8) comprising alkali chloride alkali sulfate-ZnCl₂ is contained in a carrier gas formed from an inert gas with an addition of 0.5 to 10% by weight of HCl; and
contacting the ceramic layer (18) with the gasphase for a period of time sufficient for an interlayer (19) having a thickness of at least 0.1 µm to form between the ceramic layer (18) and the surface.

2. Method according to claim 1, wherein the ceramic layer (18) is produced by PVD or by thermal spraying.

3. Method according to one of the preceding claims, using N2 as inert gas.

4. Method according to any of the foregoing claims, wherein the carrier gas contains 1.0 to 4.0% by weight of HCl.

5. Method according to one of the preceding claims, wherein the molten salt (8) contains ZnSO₄ as a further component.

6. Method according to any of the preceding claims, wherein the molten salt (8) contains the following components: KCl-K₂SO₄-ZnCl₂-ZnSO₄.

7. Method according to any of the preceding claims, wherein the components are contained in the molten salt (8) in a substantially equimolar composition.

8. Method according to any of the foregoing claims, wherein the ceramic layer (18) is brought into contact with the gas phase for a period of time sufficient for an intermediate layer (19) having a thickness of 0.5 to 5.0 µm to form between the ceramic layer (18) and the surface.

9. Method according to one of the preceding claims, with a duration of 1 to 100 hours, preferably 20 to 75 hours.

10. An article having a surface formed of a Ni-base alloy (17), said surface being coated with a ceramic layer (18) containing ZrO₂ as a main constituent with the interposition of an intermediate layer (19), and said ceramic layer (18) having an adhesive strength of at least 10 MPa or said ceramic layer (18) having a thermal cycle resistance of more than 4, wherein the article is heated to a temperature of 1100°C to determine the cycle resistance, held at this temperature for 30 minutes and then cooled to room temperature in air,
**characterized in that**
a porosity of the ceramic layer (18) within the ceramic layer (18) increases from an interface to the intermediate layer (19) toward a layer surface of the ceramic layer (18), wherein the porosity is 0.5 to 3.0% in a first layer portion adjacent to the intermediate layer and 2.5 to 6.0% in a second layer portion adjacent to the layer surface.

11. Article according to claim 10, wherein the intermediate layer (19) has a thickness of at least 0.1 µm, preferably 0.5 to 5.0 µm.

12. Article according to any one of claims 10 or 11, wherein the Ni-based alloy (17) contains Cr in an amount of 15 to 25% by weight.

13. Article according to any one of claims 10 to 12, wherein the ceramic layer (18) contains Y₂O₃ as a minor component for stabilizing ZrO₂.

14. Article according to any one of claims 10 to 13, wherein the ceramic layer (18) contains Al₂O₃ as another main component.

## Revendications

1. Procédé de réalisation d'une couche céramique (18) sur une surface formée à partir d'un alliage à base de nickel (17), comportant les étapes suivantes :
réalisation sur ladite surface d'une couche céramique (18) dont un constituant principal est le ZrO₂ ;
préparation d'une phase gazeuse ayant une température comprise entre 400 et 900 °C et contenant une vapeur formée à partir de sels fondus (8) comportant les constituants chlorure alcalin / sulfate alcalin / ZnCl₂, ladite vapeur étant contenue dans un gaz vecteur formé par un gaz inerte auquel 0,5 à 10 % en poids d'HCl ont été ajoutés ; et
mise en contact de la couche céramique (18) avec ladite phase gazeuse pendant une durée suffisamment longue pour qu'une couche intermédiaire (19) d'une épaisseur d'au moins 0,1 µm se forme entre la couche céramique (18) et ladite surface.

2. Procédé selon la revendication 1, en ce que la couche céramique (18) est réalisée par PVD ou par thermo-injection.

3. Procédé selon l'une des revendications précédentes, en ce que du N₂ est utilisé comme gaz inerte.

4. Procédé selon l'une des revendications précédentes, en ce que le gaz vecteur contient entre 1,0 et 4,0 en poids d'HCl.

5. Procédé selon l'une des revendications précédentes, en ce que les sels fondus (8) contiennent comme autre constituant du ZnSO₄.

6. Procédé selon l'une des revendications précédentes, en ce que les sels fondus (8) contiennent les constituants suivants : KCl-K₂SO₄-ZnCl₂-ZnSO₄.

7. Procédé selon l'une des revendications précédentes, en ce que les constituants sont contenus en un mélange sensiblement équimolaire dans les sels fondus (8).

8. Procédé selon l'une des revendications précédentes, en ce que la mise en contact de la couche céramique (18) avec la phase gazeuse se produit pendant une durée suffisamment longue pour qu'une couche intermédiaire (19) d'une épaisseur comprise entre 0,5 et 5,0 µm se forme entre la couche céramique (18) et ladite surface.

9. Procédé selon l'une des revendications précédentes, en ce que la durée est de 1 à 100 heures, de préférence de 20 à 75 heures.

10. Objet avec une surface formée à partir d'un alliage à base de nickel (17), en ce que la surface en intercalant une couche intermédiaire (19) est revêtue d'une couche céramique (18) contenant du ZrO₂ comme constituant principal, et en ce que la couche céramique (18) présente une adhérence d'au moins 10 MPa ou en ce que la couche céramique (18) présente une résistance cyclique thermique supérieure à 4, en ce que l'objet servant à déterminer la résistance cyclique est chauffé à une température de 1100 °C, est maintenu pendant 30 min à cette température puis refroidi à l'air à la température ambiante,
**caractérisé en ce qu'**une porosité de la couche céramique (18) dans la couche céramique (18) augmente d'une surface limite par rapport à la couche intermédiaire (19) vers une surface de couche de la couche céramique (18), **en ce que** la porosité dans une première partie de couche adjacente à la couche intermédiaire est de 0,5 à 3,0% et de 2,5 à 6,0% dans une deuxième partie de couche adjacente à la surface de couche.

11. Objet selon la revendication 10, en ce que la couche intermédiaire (19) présente une épaisseur d'au moins 0,1 µm, de préférence comprise entre 0,5 et 5,0 µm.

12. Objet selon d'une des revendications 10 ou 11, en ce que l'alliage à base de nickel (17) contient du Cr dans une quantité de 15 à 25% en poids.

13. Objet selon l'une des revendications 10 à 12, en ce que la couche céramique (18) contient de l'Y₂O₃ comme constituant secondaire pour la stabilisation du ZrO₂.

14. Objet selon l'une des revendications 10 à 13, en ce que la couche céramique (18) contient de l'Al₂O₃ comme autre constituant principal.
